# EUROPÄISCHE PATENTANMELDUNG

(11) **EP 4 060 096 A1**
(43) Veröffentlichungstag der Anmeldung: **21.09.2022**
(21) Anmeldenummer: 21162639.5
(22) Anmeldetag: 15.03.2021
(51) Int. Cl.: C30B 13/32, C30B 29/06, C30B 13/28, C30B 35/00

(54) **VORRICHTUNG UND VERFAHREN ZUR HERSTELLUNG EINES MONOKRISTALLINEN STABES AUS SILIZIUM IN EINER ZONENZIEHANLAGE**

(71) Anmelder: Siltronic AG, 81677 München (DE)
(72) Erfinder: Moos, Patrick, 84568 Pleiskirchen (DE)

(57) **Zusammenfassung**

Verfahren und Vorrichtung zum Ziehen eines monokristallinen Stabes aus Silizium in einer Ziehanlage zum Zonenschmelzen, enthaltend folgende Schritte
(1) das zur Verfügung stellen eines Vorratsstabes aus Silizium, der an einem Ende eine azimutale Nut umfasst;
(2) das Anbringen eines Unterteils, das drei Greifarme umfasst, wobei ein Greif-arm so geformt ist, dass ein Ende in die azimutale Nut des Vorratsstabes passt, und ein anderes Ende rotierbar an dem Unterteil angebracht ist;
(3) das Einhängen des Unterteils zusammen mit dem Vorratsstab an ein Ober-teil, das ein Verbindungselement enthält, das mit einer Ziehwelle der Zonenziehanlage verbunden ist, so dass das Oberteil und das Unterteil radial form-schlüssig miteinander verbunden sind, wobei das Oberteil ein Element zur radialen Ausrichtung enthält und drei in der Länge verstellbare Abstandselements so am Oberteil angebracht ist, dass sie Kraft auf jeweils einen Greifarm ausüben können;
(4) Verfahren des Elements zu radialen Ausrichtung, so dass die Rotationsachse des Vorratsstabes am Ende, an dem sich die Nut befindet, mit der Rotationsach-se der Ziehwelle übereinstimmt;
(5) Einstellen der in der Länge verstellbares Abstandselemente, so dass die Rotationsachse des Vorratsstabes am Ende, das gegenüber der Nut liegt, mit der Rotationsachse der Ziehwelle übereinstimmt;
(6) Ziehen eines konischen Teile eines monokristallinen Stabes;
(7) Ziehen eines zylindrischen Teiles des monokristallinen Stabes.

## Beschreibung

Gegenstand der Erfindung ist eine Vorrichtung und ein Verfahren zur Herstellung eines monokristallinen Stabes aus Silizium in einer Zonenziehanlage wobei ein azimutal genuteter Vorratsstab verwendet wird.

In industriellem Maßstab wird das Zonenziehen insbesondere zur Herstellung von Einkristallen aus Silizium eingesetzt. Ein Einkristall wird dabei aus einem polykristallinen Vorratsstab ("feed rod") gewonnen, wobei wahlweise auch ein Vorratsstab aus monokristallinem Silizium verwendet werden kann.

Der Vorratsstab wird hierzu an einem Ende mit Hilfe einer Hochfrequenzspule ("inductor") angeschmolzen und ein einkristalliner Impfkristall an den entstandenen Schmelzentropfen angesetzt. Vom Vorratsstab nach und nach geschmolzenes Material dient als Nachschub für einen am Impfkristall in der Folge wachsenden Einkristall. Zunächst wird ein als Dünnhals ("neck") bezeichneter Längenabschnitt kristallisiert, um Versetzungen aus dem Kristallgitter zu lenken. Anschließend wird der Durchmesser des wachsenden Einkristalls in einem als Anfangskonus ("seed cone") bezeichneten Längenabschnitt auf einen Soll-Durchmesser aufgeweitet. Danach erzeugt man einen Längenabschnitt, in dem der Einkristall den Soll-Durchmesser aufweist. Zum Schluss des Verfahrens wird noch ein als Endkonus ("end cone") bezeichneter Längenabschnitt erzeugt. Wahlweise kann das Verfahren auch ohne Endkonus abgeschlossen werden, wobei dann aber ein Teil am Ende des Längenabschnitts mit dem Soll-Durchmesser für die vorgesehene weitere Verarbeitung unbrauchbar ist, weil er Versetzungen aufweist.

Der Vorratsstab wird dabei mit einem Ende so an eine rotierbare Welle (Ziehwelle) montiert, dass er -auch wenn sich die Drehrichtung abrupt ändert- keinen Schlupf erfährt. Zudem ist die Anforderung, dass sich die Mitte des anderen Endes des Vorratsstabes während des Kristallziehens zu jedem Zeitpunkt auf der Rotationsachse der Ziehwelle befindet. Würde sich das Zentrum des anderen Endes von der Rotationsachse der Ziehwelle wegbewegen, würde das zu einer erheblichen Beeinflussung des Abschmelzens durch die Ziehspule führen, was wiederum das gesamte Ziehverfahren negativ beeinflussen kann.

Sehr leicht beobachten kann man diesen Effekt, wenn die Frequenz der Hochfrequenzspule (Ziehspule) als Funktion der Zeit gemessen wird, da die Frequenz lastabhängig und damit eine Funktion des Abstands des Vorratsstabes zur Spule ist.

Derzeit sind auf dem Markt monokristalline Stäbe aus Silizium mit einem Durchmesser von nominell bis zu 200 mm erhältlich, die mit dem Zonenziehverfahren hergestellt wurden. Der Zieldurchmesser des monokristallinen Stabes bestimmt dabei neben der Länge des zu ziehenden Stabes naturgemäß das dafür notwendige Gewicht des Vorratsstabes.

Die Entwicklung hin zu längeren monokristallinen Stäben zur Ausbeutesteigerung und auch die Entwicklung hin zu größeren Durchmessern des monokristallinen Stabes bedingen daher zwingend ein größeres Gewicht des jeweiligen Vorratsstabes, der in die Ziehanlage eingebaut und dort an der Ziehwelle sowohl präzise und fest gehalten werden muss.

Die Patentanmeldung JP 2019 167 254 A2 beschreibt beispielsweise eine Vorrichtung zum Halten eines Vorratsstabs in einer Anlage zum Zonenschmelzen, das ein Verbindungselement zwischen Ziehwelle und Vorratsstab, eine Vielzahl von Verriegelungsteilen, ein horizontales Positionierungsteil zum Einstellen der horizontalen Position des Vorratsstabes und ein Abschirmteil zum Abschirmen von Strahlungswärme enthält.

Die im genannten Stand der Technik beschriebene Vorrichtung ist prinzipiell geeignet, um Vorratsstäbe in einer Anlage zum Zonenziehen zu positionieren. Es stellte sich aber ins besondere bei der Verwendung von Vorratsstäben mit sehr hohen Gewicht und großen Längen heraus, dass sich der Einbau als zu unsicher und damit auch zu unpräzise erweist. Zudem ist die Vorrichtung nicht einfach anzubringen, so dass der schwere Vorratsstab kompliziert und meist Risiko behaftet in die Ziehanlage verbracht und dort fixiert werden muss. Der zweite Nachteil besteht darin, dass es keine Einstellmöglichkeit bezüglich des Winkels des Vorratsstabes hinsichtlich seiner Ideallinie in der Ziehanlage gibt oder diese nur schwer zu optimieren ist, was dazu führt, dass die Ausbeute der gezogenen Stäbe verringert ist.

Die Aufgabe der Erfindung ist es daher, eine verbesserte Form der Vorrichtung des Standes der Technik zur Verfügung zu stellen, die die eben aufgezeigten Nachteile nicht aufweist.

Ferner ist es Aufgabe der Erfindung, ein Verfahren zum Einbau eines Vorratsstabes zur Verfügung zu stellen, das in der Lage ist, auch sehr schwere Vorratsstäbe sicher und präzise in die Zonenziehanlage einzubauen.

Die Aufgabe wird gelöst durch die in den Ansprüchen beschriebenen Verfahren und Vorrichtungen.

Die bezüglich der vorstehend aufgeführten Ausführungsformen des erfindungsgemäßen Verfahrens angegebenen Merkmale können entsprechend auf die erfindungsgemäßen Produkte übertragen werden. Umgekehrt können die bezüglich der vorstehend ausgeführten Ausführungsformen der erfindungsgemäßen Produkte angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

### Kurzbeschreibung der Figuren

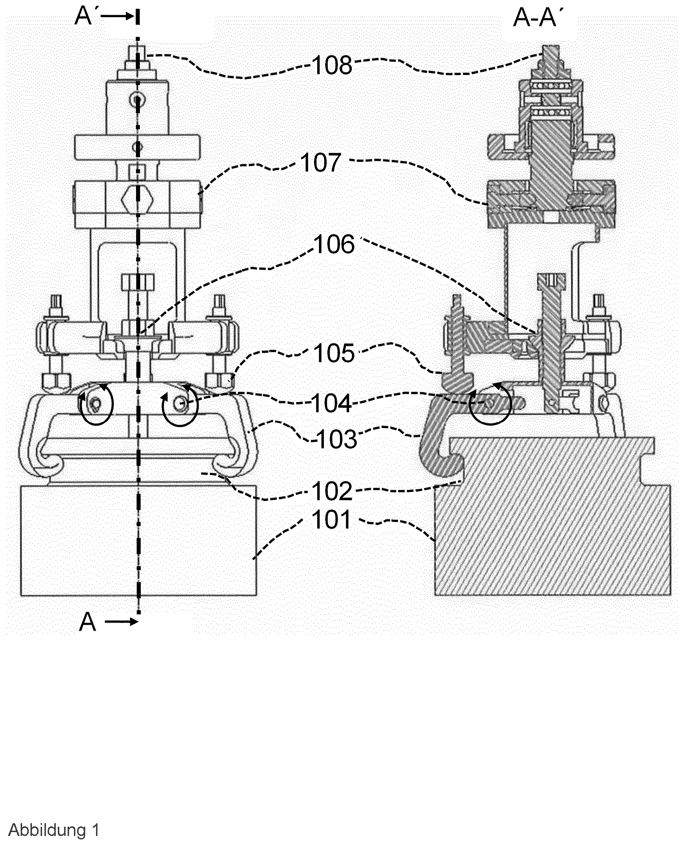

**Abbildung 1** zeigt eine erfindungsgemäße Ausprägung einer Anordnung zum Halten eines Vorratsstabes (**101**) in einer Kristallziehanlage zum Zonenziehen.
   Ein oben liegendes Verbindungselement (**108**) in Form eines Adapters, der an der Ziehwelle angebracht ist, hält ein Element zur radialen Ausrichtung der Vorrichtung (107). Das Verbindungselement (**108**) ist bevorzugt so ausgestaltet, dass es an die Ziehwelle mittels eines Gewindes angeschraubt werden kann, gleichzeitig ist es durch Bolzen gesichert, so dass sich das Gewinde nicht selbstständig durch einen plötzlichen Drehrichtungswechsel der gesamten Anordnung öffnen kann.
   Anschließend ist ein Element zur radialen Ausrichtung (**107**) der Anordnung angebracht. Die beinhaltet beispielhaft Linearführungen, die dafür sorgen, dass eine radiale Ausrichtung er Anordnung durchgeführt werden kann.
   Drei Greifer (**103**) halten mit einem Ende eine azimutalen Nut (**102**) des Vorratsstabes (**101**), wobei die Nut in der Nähe des Endes des Vorratsstabes angebracht ist.
   Die Greifarme oder Greifer (**103**) sind dabei mittels Bolzen oder Splinte (**104**) so an einem Unterteil der Vorrichtung angebracht, dass sie rotieren können und so den Vorratsstab greifen können. Mit Hilfe von Schrauben (**105**), die am Oberteil so angebracht sind, dass sie Kraft auf die Greifer ausüben können, kann der Vorratsstab (**101**) zu einen fixiert, und zum anderen so ausgerichtet werden, dass das entfernte Ende des Vorratsstabes (**101**) genau zentrisch ausgerichtet ist.

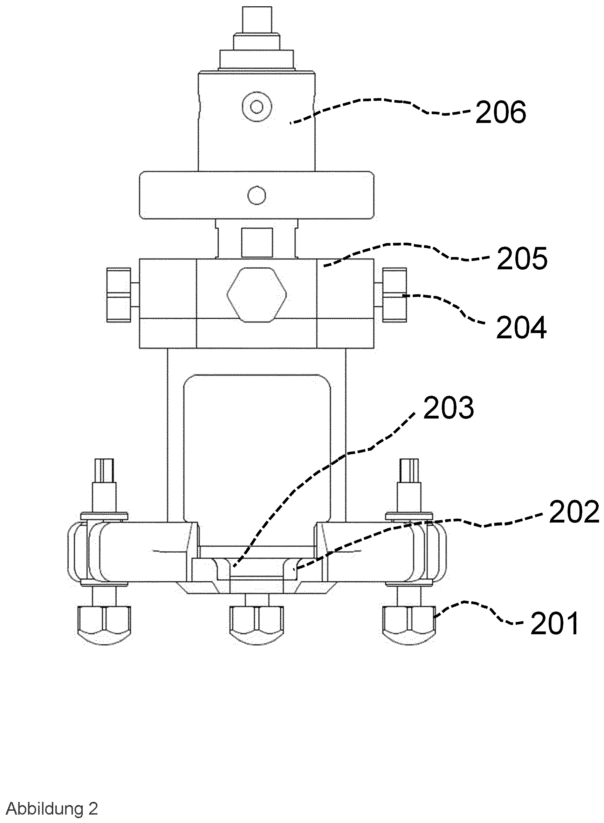

**Abbildung 2** zeigt das Oberteil einer erfindungsgemäßen Ausgestaltung der Vorrichtung. Das Oberteil kann über einen Adapter (**206**) an der Ziehwelle angeschraubt und über Bolzen gesichert werden. Das Sichern mittels Bolzen gebietet sich, da die Gesamtanordnung schnellen Rotationswechsel ausgesetzt ist und so das selbstständig lösen unterbunden wird.
   Anschließend ist ein Element zur radialen Ausrichtung (**205**) der Anordnung angebracht. Die beinhaltet beispielhaft Linearführungen, die dafür sorgen, dass eine radiale Ausrichtung er Anordnung durchgeführt werden kann. Die Linearführungen können mit Schreiben (**204**) bedient werden.
   Ferner beinhaltet das Oberteil ein Lager (**203**), das dazu dient, ein Unterteil einfach einzuhängen. Um das Unterteil einhängen zu können ist eine entsprechende Öffnung des Oberteils (**202**) nötig. Ferner beinhaltet das Oberteil in der Länge verstellbare Abstandselemente (**201**), die so angebracht ist, dass sie Kraft auf Greifarme ausüben kann, die am Unterteil befestigt sind. Eine einfache Ausprägung eines Abstandselements ist eine Schrauben, die mit Kontermuttern versehen ist.

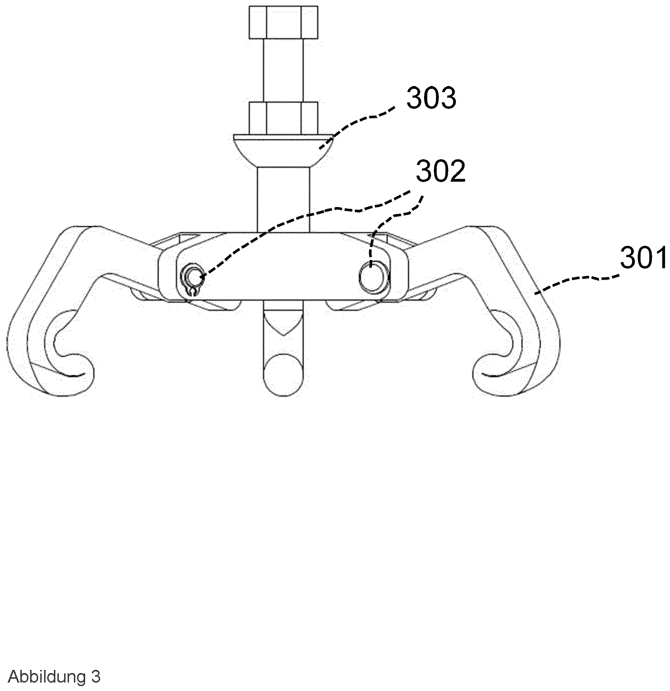

**Abbildung 3** zeigt das Unterteil einer erfindungsgemäßen Ausgestaltung der Vorrichtung. Drei Greifarme oder Greifer (**301**) sind mittels Bolzen oder Nieten (**302**) so angebracht, dass sie rotieren und so in die Nut des Vorratsstabes eingreifen können. Die Rotation der Greifarme kann dabei durch ein Schraubenmechanismus eingestellt werden und befestigt werden.
   Das Unterteil beinhaltet ein Gegenlager (**303**), so dass es einfach an das Oberteil eingehängt werden kann. Bevorzugt sind die Greifer oder Greifarme (**30**1) monolithisch aus einem Stück gefertigt.

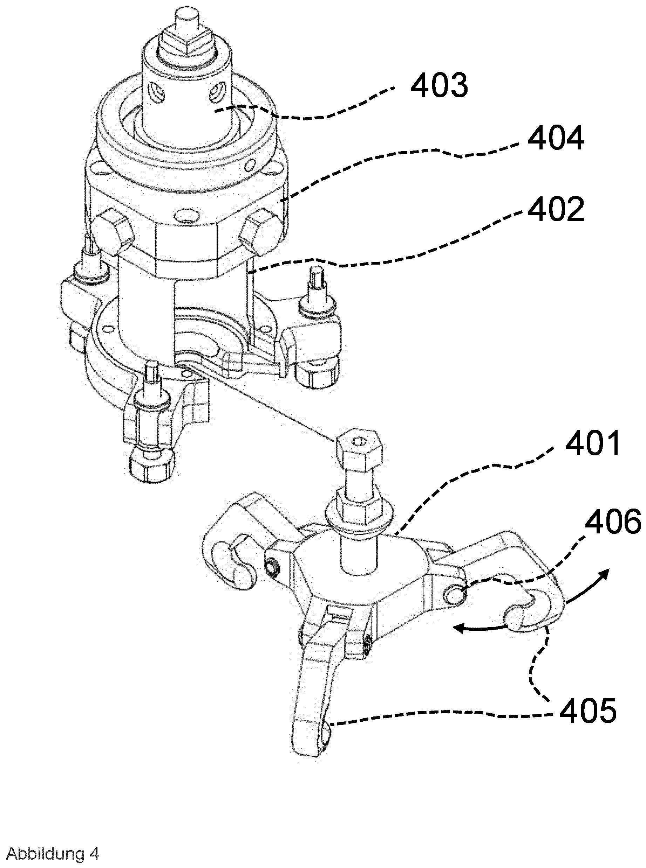

**Abbildung 4** zeigt beispielhaft wie Unterteil (**401**) in das Oberteil (**402**) eingehängt werden kann. Das Oberteil beinhaltet dabei ein Verbindungselement (**403**), das mit der Ziehwelle verbunden werden kann, und ein Element zur radialen Ausrichtung mittels einer Linearführung (**404**), mit dessen Hilfe die Vorrichtung radial ausgerichtet werden kann. Das Unterteil, das in das Oberteil eingehängt wird, beinhaltet bewegliche Greifarme (**405**), die mittels einer Niete oder Splints, der mit Sprengring gesichert sind, angebaut sind.

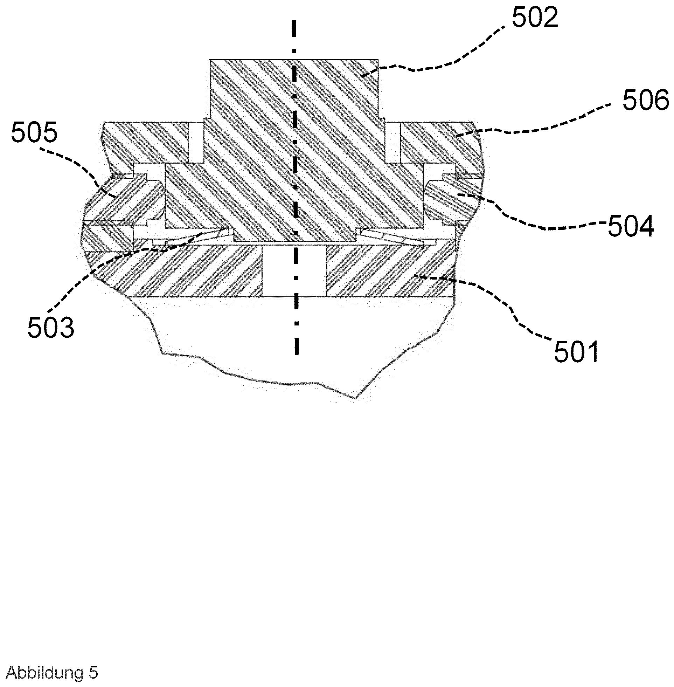

**Abbildung 5** zeigt im Detail eine erfindungsgemäße Ausprägung des Elements zur radialen Ausrichtung der Vorrichtung in der Ziehanlage (Linearführung). Auf einer Grundplatte (**501**) ruhen eine oder mehrere Blattfedern (**503**), die das Verbindungselement (**502**) tragen. Über eine Schraube (**504**) kann das Verbindungselement (**502**) präzise horizontal so verstellt werden, dass die Position des in der Vorrichtung eingehängten Stabes den Vorgaben entspricht. Eine Schraube (**505**) wird dabei zum Kontern der Linearführung verwendet, um die eingestellte Position zu sichern.

### Abkürzungen

- **101**: Vorratsstab. Der Vorratsstab kann aus polykristallinem oder monokristallinem Halbleitermaterial bestehen.
- **102**: Azimutale Nut an einer Seite eines Vorratsstabs (**101**). Die Nut ist im gezeigten Beispiel asymmetrisch ausgeführt, das heißt der Durchmesser des Vorratsstabes unterscheidet sich links und rechts der Nut voneinander.
- **103**: Greifarm, der so geformt ist, dass ein Ende in die azimutale Nut des Vorratsstab (**102**) passt, und ein anderes Ende rotierbar an dem Unterteil befestigt ist.
- **104**: Niete, an der ein Ende des Greifarms so angebracht ist, so dass der Greifarm drehen kann.
- **105**: Schraube (ein in der Länge verstellbares Abstandselement am Oberteil so angebracht ist, dass es Kraft auf einen Greifarm ausüben kann)
- **106**: selbstzentrierend und lösbar miteinander verbunden
- **107**: Element zur radialen Ausrichtung
- **108**: oben liegendes Verbindungselement

- **201**: Schraube (ein in der Länge verstellbares Abstandselement am Oberteil so angebracht ist, dass es Kraft auf einen Greifarm ausüben kann)
- **202**: Öffnung, um das Unterteil einhängen zu können
- **203**: Lager für das Unterteil
- **204**: Schrauben zum horizontalen verstellen in der Linearführung
- **205**: Element zur radialen Ausrichtung mittels einer Linearführung
- **206**: oben liegendes Verbindungselement

- **301**: Greifarm
- **302**: Niete oder Splint, der mit Sprengring gesichert ist.
- **303**: Gegenlager, um das Unterteil in das Oberteil einhängen.

- **401**: Unterteil
- **402**: Oberteil
- **403**: oben liegendes Verbindungselement
- **404**: Element zur radialen Ausrichtung mittels einer Linearführung
- **405**: bewegliche Greifarme
- **406**: Niete oder Splint, der mit Sprengring gesichert ist.

- **501**: Grundplatte
- **502**: Verbindungselement
- **503**: Blattfeder
- **504**: Schraube zum horizontalen verstellen in der Linearführung
- **505**: Schraube zum Kontern der Linearführung
- **506**: Abdeckung

### Detaillierte Beschreibung erfindungsgemäßer Ausführungsbeispiele

Der Erfinder hat nach Analyse der genannten Problematik erkannt, dass eine bevorzugte Lösung der genannten Problematik darin besteht, eine Vorrichtung zum Halten für den Vorratsstab so zu konstruieren, dass sie zumindest zweiteilig ist, wobei ein Teil (im Folgenden "Unterteil" genannt) an den Stab montiert werden kann, während er sich noch außerhalb der Kristallziehanlage befindet. Der zweite Teil der Vorrichtung (im Folgenden "Oberteil" genannt) wird an der Ziehwelle in der Kristallziehanlage festmontiert.

Als Ziehwelle bezeichnet man die Vorrichtung, die im Wesentlichen zwei Aufgaben in der Ziehanlage erfüllt: (1) Sie sorgt dafür, dass der an ihr befestigte Vorratsstab mit gegebenenfalls sich ändernden Drehgeschwindigkeiten oder/und Drehrichtungen gehalten wird und (2) dass der Vorratsstab mit einer vorher festgelegten (oder gegebenenfalls sich ändernden) Geschwindigkeit axial verfahren werden kann.

Der Vorratsstab hält dabei das Material vor, aus dem der spätere Einkristall gefertigt werden soll. Zum Ziehen eines Einkristall aus Silizium wird beispielsweise ein polykristalliner Vorratsstab aus Silizium verwendet. Selbstredlich kann auch ein monokristalliner Kristall, der zum Beispiel mittels einem Ziehverfahren nach Czochralski gezogen ist auch als Vorratsstab verwendet werden. Es ist auch möglich, andere Halbleitermaterialien für den Vorratsstab zu verwenden.

Wesentlich für den Vorratsstab ist, dass er die Form eines Zylinders aufweist, wobei seine Mantelfläche eine Nut in der Nähe einer Seite (Oberseite) aufweist, die so dimensioniert ist, dass der Vorratsstab gehalten werden kann, ohne auszubrechen. **Abbildung 1** zeigt hierzu exemplarisch einen Vorratsstab **(101)** mit einer entsprechend ausgeführten Nut (**102**).

Das Gewicht eines Vorratsstabes kann je nach des gewünschten Durchmessers und der Länge des monokristallinen Stabes variieren. Ein typisches Gewicht für monokristalline Stäbe aus Silizium kann dabei weit mehr als 100 kg betragen und in manchen Fällen sogar mehr als 200 kg.

Das Fixieren so eines schweren Vorratsstabes in einer Ziehanlage mit den im Stand der Technik zur Verfügung stehenden Mitteln ist schwierig, zeitintensiv und birgt Risiken. Das Gewicht des Vorratsstabs muss dabei in der Ziehanlage präzise aufrechtstehend so lange gehalten werden, bis er an der Ziehwelle montiert und ausgerichtet ist.

Wenn die Ausrichtung unzureichend erfolgt, kann dies beim Kristallziehen zu einem Schwingen der Senderfrequenz führen, was oftmals zu einem Stabausfall (Bruch, oder Versetzung) führt.

Der Erfinder hat erkannt, dass bevorzugt zuerst ein Unterteil einer erfindungsgemäßen Vorrichtung an den Vorratsstab angebracht wird, während der Vorratsstab sich noch außerhalb der Ziehanlage befindet. Besonders bevorzugt liegt der Vorratsstab dabei in der Horizontalen.

Dabei enthält das Unterteil der erfindungsgemäßen Vorrichtung (wie zum Beispiel in **Abbildung 3** gezeigt) bevorzugt drei Greifarme oder Greifer (**301**), die an der Vorrichtung mittels Bolzen oder Nieten (**302**) so angebracht sind, dass sie rotieren können.

Beim Anbringen des Unterteils an den Vorratsstab fassen die Greifer **(301, 103)** in die Nut **(102)** des Vorratsstabes **(101)** und fixieren es dort.

Im Zentrum des Unterteils befindet sich eine Verstellschraube, die dazu verwendet werden kann, alle Greifarme gleichzeitig zu öffnen beziehungsweise zu schließen. Mit Hilfe dieser Verstellschraube wird das Unterteil an dem Vorratsstab über die Greifarme befestigt.

Der Vorratsstab wird bevorzugt zusammen mit dem an ihn montierten Unterteil der Vorrichtung in die Ziehanlage eingebaut.

Dabei wird das Gegenlager (**303**) des Unterteils zunächst in ein Lager des Oberteils (**203**) eingehängt. Dieses Lager ist bevorzugt so ausgestaltet, dass das Unterteil einfach eingehängt werden kann, insbesondere ist eine entsprechende Öffnung des Oberteils (**202**) hierfür nötig, die einen seitlichen Zugang hierfür ermöglicht.

Das Unterteil ist damit mit dem Oberteil radial formschlüssig miteinander verbunden, wobei das verwendete Lager bewirkt, dass die Verbindung zusätzlich selbstzentrierend und zudem lösbar miteinander verbunden sind.

Das Oberteil beinhaltet bevorzugt ein Element, das zur radialen Ausrichtung des Vorratsstabes dient. Das Oberteil enthält bevorzugt eine Linearführung, mit dessen Hilfe der Vorratsstab so eingestellt werden kann, dass die Rotationsachse der Ziehwelle mit der Rotationsachse des Vorratsstabes übereinstimmt. Die Linearführung ist dabei bevorzugt so angeordnet, dass der Verfahrweg senkrecht zur Rotationsachse der Ziehwelle ist.

Beim Einrichten wird bevorzugt zuerst die Linearführung dazu benutzt, um den Vorratsstab so einzurichten, dass die Rotationsachse der im Vorratsstab befindlichen Nut mit der Rotationsachse der Ziehwelle übereinstimmt. Die gewünschte Position der Linearführung wird anschließend bevorzugt von den in der Vorrichtung befindlichen Schrauben zum Kontern (505) gesichert. Der Erfolg der Maßnahme kann zum Beispiel dadurch überprüft werden, dass die Ziehwelle mit dem daran befestigten Vorratsstab rotiert wird und dabei das Rundlaufverhalten überprüft wird.

Das Oberteil beinhaltet bevorzugt ebenfalls in der Länge verstellbare Abstandselemente (**105**), wie zum Beispiel Schrauben, die so angebracht ist, dass sie Kraft auf die Greifarme (**103**) ausüben können, die am Unterteil befestigt sind.

Das Einstellen dieser in der Länge verstellbaren Abstandselemente (**201**) bewirkt, dass der Vorratsstab entlang seiner Achse ausgerichtet werden kann. Bevorzugt wird der Vorratsstab dabei so eingerichtet, dass die Rotationsachse der Ziehwelle mit der Rotationsachse des Vorratsstabes übereinstimmt. Insbesondere wird darauf geachtet, dass die Rotationsachse am Ende des Vorratsstabes, das der Nut gegenüberliegt, mit der Rotationsachse der Ziehwelle übereinstimmt. Überprüft werden kann dies, indem dabei das Rundlaufverhalten überprüft wird.

**Abbildung 1** zeigt in zwei Ansichten einen Vorratsstab (**101**), der in die erfindungsgemäße Vorrichtung eingespannt ist.

Nachdem der Vorratsstab eingesetzt ist, kann die Anlage geschlossen und mit dem Kristallziehen begonnen werden, wobei zuerst ein Anfangskonus gezogen wird, der nach Erreichen eines Zieldurchmessers in einen zylindrischen Teil übergeht. Nach Erreichen einer gewünschten Länge des monokristallinen Stabes wird ein Endkonus gezogen. Nach Beendigung des Kristallziehens kann der monokristalline Stab der Anlage entnommen und ein neuer Vorratsstab vorbereitet werden.

Idealerweise wird während des Kristallziehens eines ersten Kristalls schon an einem Vorratsstab eines Unterteil im Sinne der Erfindung angebracht, was die Rüstzeiten der Anlage weiter erheblich verringert.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Vorrichtung zur Herstellung eines monokristallinen Stabes aus einem azimutal genuteten Vorratsstabes, der an einer Ziehwelle in einer Ziehanlage zum Zonenschmelzen gehalten wird, enthaltend
ein Oberteil,
umfassend ein Verbindungselement, das zum Einbau in die Ziehanlage dient, und ein Element zur radialen Ausrichtung des Oberteils in der Ziehanlage,
und ein Unterteil
das drei Greifarme umfasst, wobei ein Greifarm so geformt ist, dass ein Ende in die azimutale Nut des Vorratstabes passt, und ein anderes Ende rotierbar angebracht ist,
wobei das Oberteil und das Unterteil radial formschlüssig, selbstzentrierend und lösbar miteinander verbunden sind.

2. Vorrichtung nach Anspruch 1, **dadurch gekennzeichnet, dass** das Element zur radialen Ausrichtung Linearführungen umfasst, die so angeordnet sind, dass die jeweilige lineare Führung senkrecht zur Ziehwelle erfolgen kann.

3. Vorrichtung nach Anspruch 1, **dadurch gekennzeichnet, dass** ein Greifarm monolithisch aus einem Stück gefertigt wurde.

4. Vorrichtung nach einem der vorstehenden Ansprüche, **dadurch gekennzeichnet, dass**
ein in der Länge verstellbares Abstandselement am Oberteil so angebracht ist, dass es Kraft auf einen Greifarm ausüben kann.

5. Verfahren zum Ziehen eines monokristallinen Stabes aus Silizium in einer Ziehanlage zum Zonenschmelzen, enthaltend folgende Schritte
(1) das zur Verfügung stellen eines Vorratsstabes aus Silizium, der an einem Ende eine azimutale Nut umfasst;
(2) das Anbringen eines Unterteils, das drei Greifarme umfasst, wobei ein Greifarm so geformt ist, dass ein Ende in die azimutale Nut des Vorratsstabes passt, und ein anderes Ende rotierbar an dem Unterteil angebracht ist,
(3) das Einhängen des Unterteils zusammen mit dem Vorratsstab an ein Oberteil, das ein Verbindungselement enthält, das mit einer Ziehwelle der Zonenziehanlage verbunden ist, so dass das Oberteil und das Unterteil radial formschlüssig miteinander verbunden sind, wobei das Oberteil ein Element zur radialen Ausrichtung enthält und drei in der Länge verstellbare Abstandselements so am Oberteil angebracht ist, dass sie Kraft auf jeweils einen Greifarm ausüben können.;
(4) Verfahren des Elements zu radialen Ausrichtung, so dass die Rotationsachse des Vorratsstabes am Ende, an dem sich die Nut befindet, mit der Rotationsachse der Ziehwelle übereinstimmt;
(5) Einstellen der in der Länge verstellbares Abstandselemente, so dass die Rotationsachse des Vorratsstabes am Ende, das gegenüber der Nut liegt, mit der Rotationsachse der Ziehwelle übereinstimmt;
(6) Ziehen eines konischen Teile eines monokristallinen Stabes
(7) Ziehen eines zylindrischen Teiles des monokristallinen Stabes.
